# EUROPEAN PATENT APPLICATION

(11) **EP 2 688 117 A1**
(43) Date of publication of application: **22.01.2014**
(21) Application number: 12005316.0
(22) Date of filing: 20.07.2012
(51) Int. Cl.: H01L 51/00

(54) **Process for forming a layer of an organic electronic device**

(71) Applicant: SOLVAY SA, 1120 Bruxelles (BE)
(72) Inventor: Maunoury, Jonathan, 1030 Brussels (BE); Orselli, Enrico, 1050 Brussels (BE)
(74) Representative: Langfinger, Klaus Dieter

(57) **Abstract**

A process for forming an organic layer of an organic electronic device comprising the steps of providing a liquid composition containing an organic semiconducting material and a solvent preparation and depositing the liquid composition onto a surface of a substrate wherein a solvent preparation is used which has a water content of 40 ppm or less, based on the weight of the solvent preparation.

## Description

The present invention relates process of forming an organic layer for an organic electronic device where a liquid composition containing an organic semiconducting material and a solvent preparation is deposited onto the surface of a substrate.

Today, various display devices are under active study and development, in particular those based on electroluminescence (EL) from organic materials.

In contrast to photoluminescence, i.e. the light emission from an active material as a consequence of optical absorption and relaxation by radiative decay of an excited state, electroluminescence (EL) is a non-thermal generation of light resulting from the application of an electric field to a substrate. In this latter case, excitation is accomplished by recombination of charge carriers of contrary signs (electrons and holes) injected into an organic semiconductor in the presence of an external circuit.

A simple prototype of an organic light-emitting diode (OLED), i.e. a single layer OLED, is typically composed of a thin film of an active organic material which is sandwiched between two electrodes, one of which needs to have a degree of transparency sufficient in order to observe light emission from the organic layer.

If an external voltage is applied to the two electrodes, charge carriers, i.e. holes, at the anode and electrons at the cathode are injected to the organic layer beyond a specific threshold voltage depending on the organic material applied. In the presence of an electric field, charge carriers move through the active layer and are non-radiatively discharged when they reach the oppositely charged electrode. However, if a hole and an electron encounter one another while drifting through the organic layer, excited singlet (anti-symmetric) and triplet (symmetric) states, so-called excitons, are formed. Light is thus generated in the organic material from the decay of molecular excited states (or excitons). For every three triplet excitons that are formed by electrical excitation in an OLED, one anti-symmetric state (singlet) exciton is created.

High efficiency OLEDs based on organic semiconducting materials usually comprise a multiplicity of different layers, each layer being optimized towards achieving the optimum efficiency of the overall device.

One exemplary type of such OLEDs comprise at least five layers: an usually p-doped injection layer (also referred to as hole injection layer or HIL), a usually undoped hole transport layer (HTL), at least one emissive layer (EML), a usually undoped hole blocking layer (HBL) and a usually n-doped electron transport layer (ETL). This kind of devices is generally known as p-i-n OLED.

However, p-i-n-OLEDS are not the only OLED devices suitable and other stacking sequences of layers, which may be doped or undoped are known.

In order to achieve an optimum efficiency, the physical properties of each material for each individual layer of the stack (as e.g. carrier transport properties, HOMO and LUMO levels, triplet levels) have to be optimised depending on the functionality of the layer. As a result thereof, chemical composition and molecular structure of the materials usually differ from each other and the OLED stack of such a device is referred to as a heterojunction device.

Until today, multilayer OLEDs based on organic semiconducting materials are prepared generally by vacuum deposition technologies whereby the layers are consecutively deposited on each other from the gas phase. In vacuum evaporation processes organic molecules are heated, evaporated and then condensed onto the substrate. A mask has to be used to pattern an organic layer for the actual pixels which makes the method relatively inefficient and expensive as most of the evaporated material is wasted (it does not end up on the substrate).

In accordance with the organic vapour deposition method, the organic materials are transported to the substrate with a carrier gas, which makes this process more efficient that the vacuum evaporation process, but there is still improvement in efficiency and economics desirable.

The preparation of multilayered systems through solution based methods would be desirable but until today the performance properties of organic electronic devices obtained thereby are usually inferior to respective devices prepared by vapor deposition.

Thus, there still exists a need for an economical process for the manufacture of high performance OLEDs avoiding at least partly the disadvantages of the prior art described above.

Accordingly it was an object of the present invention to provide a process for the manufacture of organic electronic devices, in particular organic light emitting diodes with good performance properties by solution based technologies.

This object has been achieved with a process as claimed in claim 1.

The present invention relates to a process for forming an organic layer of an organic electronic device comprising the steps of providing a liquid composition containing an organic semiconducting material and a solvent preparation and depositing the liquid composition onto a surface wherein the solvent preparation has a water content of 40 ppm or less, based on the weight of the solvent preparation.

Preferred embodiments of the present invention are set forth in the dependent claims and the detailed specification hereinafter.

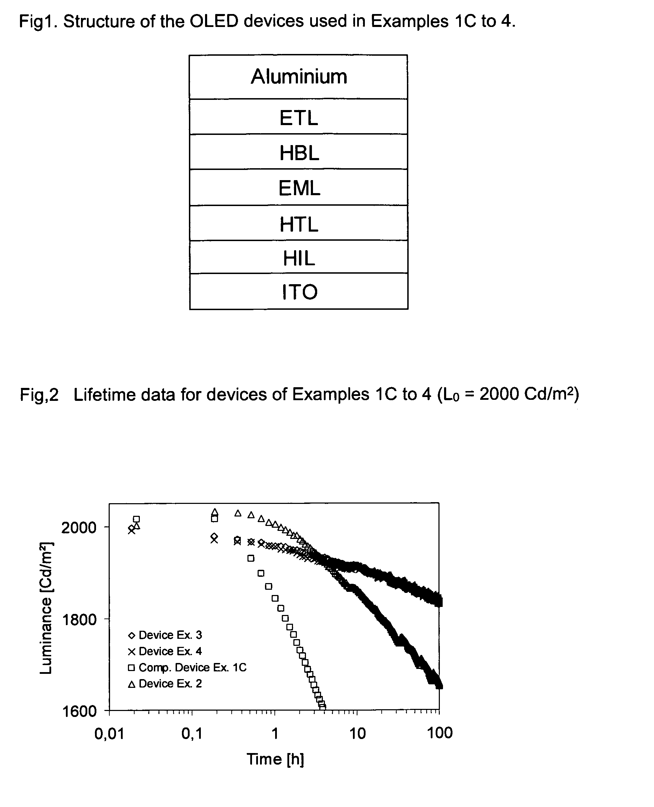

Figure 1 shows the principal structure of the OLED devices used in Examples 1C to 4.
Fig. 2 shows the lifetime data for the devices manufactured in Examples 1C to 4.

In accordance with preferred embodiments of the process of the present invention, the solvent preparation has a water content of 25 ppm, even more preferably of 15 ppm or less.

In some cases it has been found useful to reduce the water content even below 10 ppm or to less than 5 ppm and in some cases even to less than 2 ppm.

For the purpose of the present invention, the terms "solvent preparation" is intended to denote a material consisting essentially of one or more solvents, and, optionally in addition the mentioned maximum amounts of water and, optionally other impurities sometimes found in solvents like e.g. halogens like F, Cl, Br or I or metals like Ag, Al, Au, B, Ba, Be or Ca or compounds of these metals to name just a few examples Preferably, the total amount of halogens in the solvent preparation does not exceed 2 ppm, in particular it is 0,5 ppm at maximum. The maximum content of metals or metal compounds in the solvent preparation is preferably less than 5 ppb and particularly preferred less than 1.5 ppb. The one or more solvents in the solvent preparation represent preferably at least 99.8 wt. % of the solvent preparation. In accordance with a further preferred embodiment the solvent preparation used in the process in accordance with the present invention has a content of other impurities than the ones mentioned above of less than 0.1 % by wt. preferably less than 0.05 wt%, , based on the solvent preparation. In particular it has proven advantageous in certain cases to keep the content of other impurities (than the ones mentioned above) having a boiling point exceeding the boiling point of the solvent wioth the highest boiling point in the solvent preparation at a maximum 0f 0.05 wt%.

The solvents forming part of the solvent preparation may be aliphatic or aromatic in nature and may comprise one or more than one functional groups in the molecule.

In the context of the present invention the meaning of certain terms as used herein is as follows:

The term "aliphatic" as used herein is understood to denote a linear, branched or cyclic hydrocarbyl group, which may be saturated or unsaturated in the hydrocarbon chain. The carbon atoms may thus be linked by single (alkyl groups), double (alkenyl groups) or triple bonds (alkynyl groups). One or more of the hydrogen atoms in the hydrocarbyl group may be replaced by other atoms like oxygen, nitrogen, halogens or sulfur, to denote only a few examples. Furthermore, also part of the carbon atoms in the chain may be replaced by heteroatoms like e.g. silicon, nitrogen, phosphorus, oxygen or sulfur.

The term "aryl" is intended to denote a hydrocarbyl group with at least one aromatic ring and includes heteroaryl groups, i.e. groups wherein one or more carbon atoms of the hydrocarbyl group is replaced by a heteroatom like e.g. silicon, nitrogen, phosphorus, oxygen and sulfur. An aryl group may comprise one or more aromatic rings, which may be connected through one or more carbon atoms or which may share two carbon atoms (in which case fused systems are obtained).

Examples of aryl groups are benzene, naphthalene, anthracene, phenanthrene, higher fused systems, perylene, tetracene, pyrene, benzpyrene, chrysene, triphenylene, acenaphthene and fluorene and derivatives thereof. Exemplary heteroaryl groups include furane, benzufurane, thiophene, benzothiophene, pyrrole, pyrazole, triazole, imidazole, oxazole, oxadiazole, thiazole, tetrazole, indole, carbazole, pyridine, pyrimidine, triazine, quinoline, isoquinoline and the like to mention only a few examples thereof.

The solvent or solvents used in the solvent preparation in accordance with the process of the present invention is respectively are selected from solvents wherein the organic semiconducting materials have a sufficient solubility for the application of the liquid composition through e.g. spraying, inkjet printing or spin coating or in general for the deposition of the liquid composition on a substrate.

Furthermore the suitable solvents should have a boiling point in a range which enables proper deposition without solvent loss but which may, in a subsequent step after deposition, be removed prior to the application of the next layer, preferably by evaporation or application of vacuum. Accordingly, the solvents used in accordance with the process of the present invention preferably have a boiling in the range of from 80 to 300 °C (at atmospheric pressure), preferably of from 90 to 250 °C. The vapor pressure of solvents within this range is normally suitable for the deposition under atmospheric pressure without the need to use vacuum or increased pressure which requires more expensive equipment.

Suitable solvents may be derived from aromatic or aliphatic hydrocarbons which may or may not comprise functional groups like ether groups or keto groups in the molecule.

In accordance with a first preferred embodiment of the process of the present invention the solvent preparation comprises or preferably consists essentially of, most preferably consists of aromatic solvents. Aromatic solvents with substituted or unsubstituted aryl or heteroaryl groups commonly used as solvents in chemical synthesis may be mentioned here. By way of example toluene, the isomeric xylenes, solvents comprising a keto group like the isomeric tetralones or phenones like benzophenone, acetophenone or propiophenone may be mentioned here.

A second group of solvents which may be mentioned here are aromatic ether solvents having the general formula R-O-R' wherein at least one of R and R' comprises an aryl group and wherein R and R' may be the same or different.

The ether group may form part of a ring (cyclic ethers) or may connect two aryl groups or an aryl group and another group.

The boiling points of the ether solvents are preferably chosen in the range as defined above, i.e in the range of from 90 to 300 °C at atmospheric pressure.

Just by way of example, alkoxy or aryloxy-substituted aromatic or heteroaromatic solvents like phenoxytoluenes, alkoxybenzenes, anisaldehydes, alkoxytoluenes and the like may be mentioned.

Further suitable solvents suitable for use in the process of the present invention are disclosed in WO 2010/147818, the content of which is hereby incorporated by reference.

The organic semiconducting material present in the liquid composition used in the process of the present invention is a material capable of exhibiting semiconducting properties. Usually such compounds have an energy gap between the conduction and the valence bands not exceeding 4 eV.

The organic semiconducting material or materials may be selected from the groups of molecules described in the literature for use in the manufacture of organic electronic devices, e.g. organic light emitting diodes or photovoltaic cells.

For use in organic light emitting diodes, which constitute a preferred group of organic electronic devices in the manufacture of which the process of the present invention may be used, the materials usually have either charge transfer properties (hole or electron transporting) or emissive properties, in particular phosphorescent emitting properties.

The process of the present invention is suitable for small molecule organic semiconductors as well as for higher molecular weight or polymeric semiconductors and the advantages are obtained independent of the molecular structure of the organic semiconducting materials. Thus, any organic semiconducting material described in the prior art which can be dissolved in a suitable solvent preparation in sufficient concentration can be used for the process of the present invention and there is no limitation in terms of molecular weight or chemical structure of the semiconducting material. The skilled person can freely select the material based on the desired purposes of the device like emission wavelength or the like and will then chose an appropriate solvent based on his knowledge. The important fact is that the solvent preparation used has a water content not exceeding 40 ppm to achieve devices with the best properties.

In accordance with a first preferred embodiment, small organic molecules may be used. The term small molecule is intended to denote molecules of non-polymeric nature, but such molecules may comprise a limited number of repeating units in certain circumstances. In terms of molecular weight, small molecules usually have a molecular weight of 3000 Daltons or less, preferably 2000 Daltons or less.

The skilled person is also aware of polymeric organic semiconductors which have been described in the literature for the manufacture of organic electronic devices. The term polymeric usually denotes molecules having a molecular weight of 2000 Daltons or more, preferably exceeding 3000 Daltons or more.

The skilled person will select the suitable organic semiconducting material for use in the process of the present invention based on the desired emission wavelength or other parameters pre-determined by the structure of the final device and will rely on the multiplicity of materials described in the prior art.

As mentioned, the advantage of the low water content in the solvent preparation is independent of the structure of the organic semiconducting material used in the liquid composition and thus a detailed description of suitable organic semiconducting materials is not necessary here. A huge number of charge transport compounds or compounds with emissive properties has been described in the prior art and this disclosure enables the skilled person to select a suitable organic semiconducting material for the respective layer which is formed in accordance with the process of the present invention.

Furthermore, the process in accordance with the present invention is applicable to any layer of an organic electronic device which is deposited out of solution. In some cases particularly good results have been obtained if the HTL or the EML layer of an organic electronic device, in particular of an OLED was manufactured in accordance with the process of the present invention.

The concentration of the organic semiconducting material in the liquid composition may vary depending on the particular application used for depositing same onto a substrate. In some cases concentrations of from 0.01 to 20 wt.%, preferably of from 0.05 to 10 wt.% and even more preferably 0.1 to 2 wt.%, in each case based on the weight of the solvent preparation in the liquid composition, have proven to be advantageous. If the composition is applied by inkjet printing, the viscosity thereof should be within a suitable range which in turn influences the concentration of the small molecule in the composition. In addition to the organic material with semiconducting properties other type of materials used in the fabrication of organic electronic devices, e.g. OLEDs may be present in the composition. Preferably the liquid composition does not comprise further ingredients which would increase the water content of the liquid composition to a value exceeding 40 ppm. Preferably the water content of the liquid composition is 40 ppm or less, preferably 30 ppm or less and even more preferably less than 25 ppm. In some cases it has proven to be advantagoeus to reduce the water content to values of less than 10, sometimes less than 5 and even less than 2 ppm.

Without being limited in an manner as examples for organic semiconducing materials, materials fulfilling the function as host materials like CBP, mCP and mCBP, organic molecules possibly useful as emitters like e.g. DCM, DCMQA and rubrene, organic molecules possibly useful as charge transporting material like e.g. NPB, MTDATA, TCTA, TPBI or BPhen, organic molecules possibly useful as emitters and/or charge transport materials like e.g. Alq3, Flrpic, Ir(ppy)3 or Ir(ppz)3, conducting polymers possibly useful as matrices like poly(N-vinylcarbazole) (PVK), poly(phenylene vinylene) (PPV) or polyfluorenes (PF) as well as may be mentioned.

The following table 1 lists the available CAS Registry numbers for the substances mentioned before and the structures thereof are given therafter.

**Table 1**

| Substance | CAS Registry No. |
|---|---|
| CBP | 58328-31-7 |
| mCP | 550378-78-4 |
| mCBP | 342638-54-4 |
| DCM | 51325-91-8 |
| DMQA | 19205-19-7 |
| Rubrene | 517-51-1 |
| NPB | 123847-85-8 |
| MTDATA | |
| TCTA | 139092-78-7 |
| TPBI | 192198-85-9 |
| BPhen | 1662-01-7 |
| Alq3 | 2085-33-8 |
| Flrpic | 376367-93-0 |
| Ir(ppy)3 | 94928-86-6 |
| Ir(ppz)3 | |

The structures of the exemplary ingredients are reproduced below

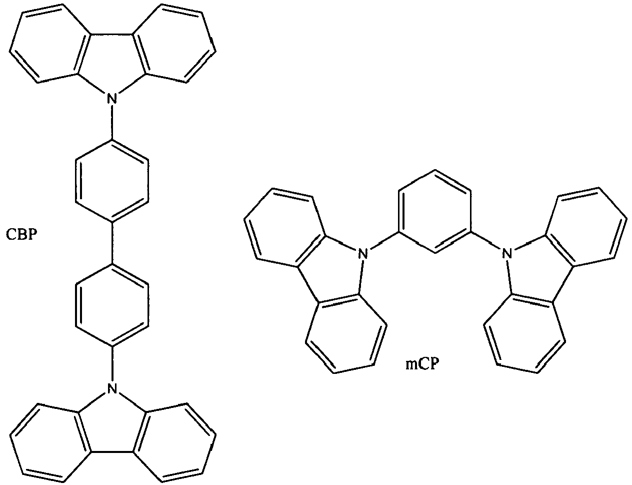

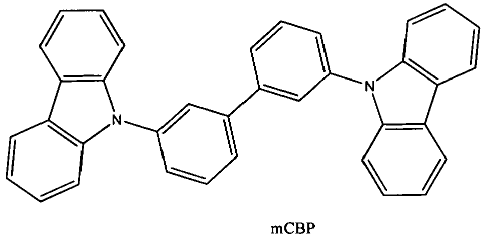

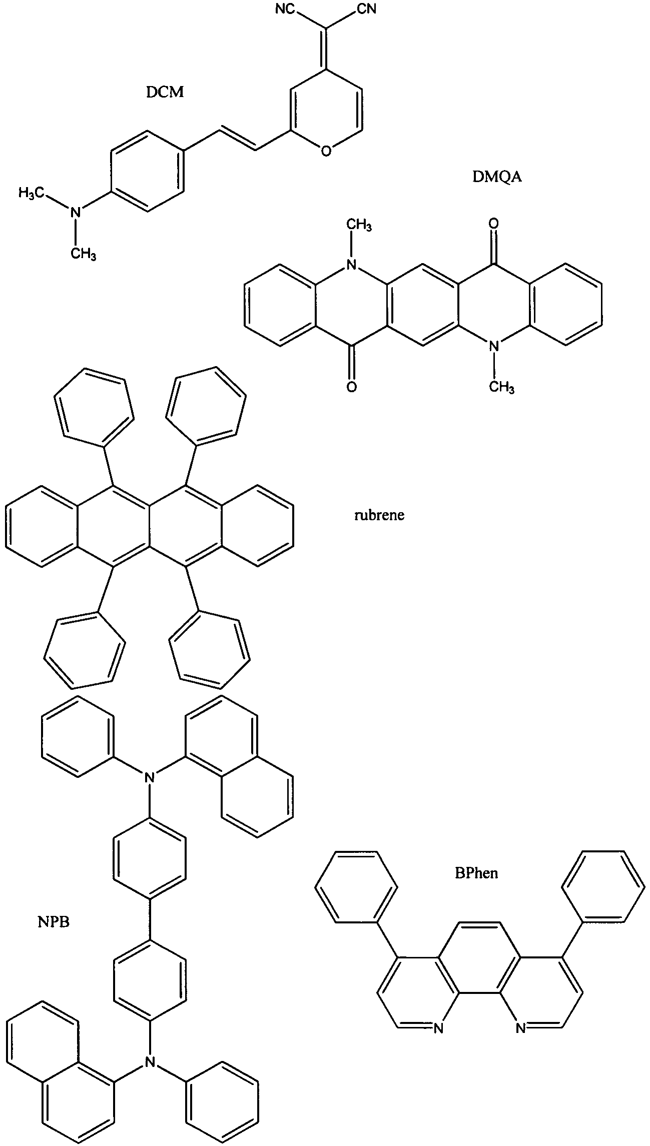

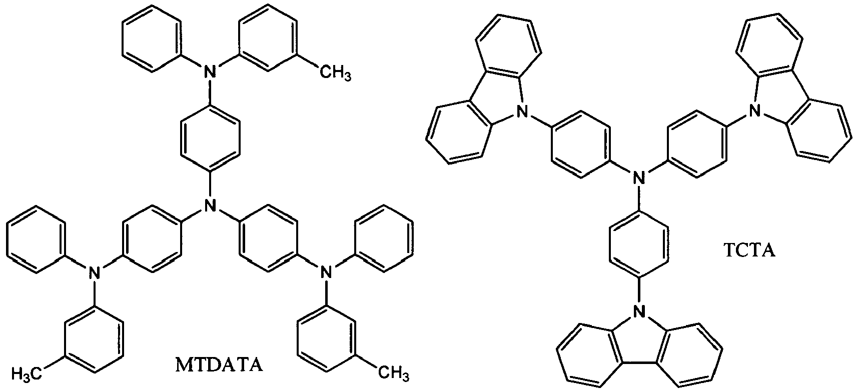

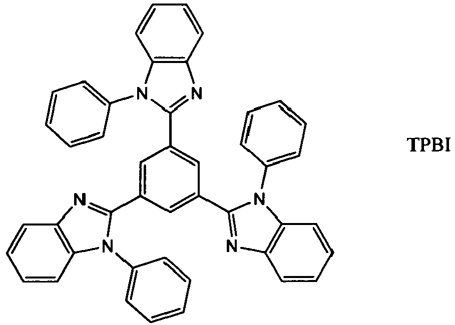

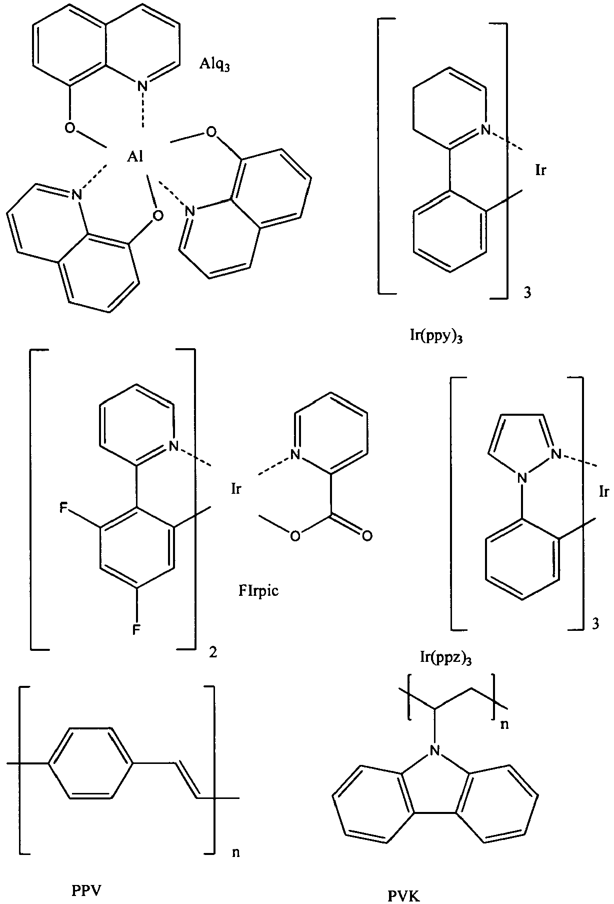

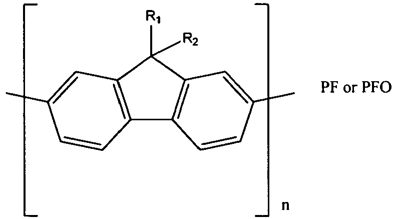

Other ingredients in addition or instead of the exemplary substances listed above may be present in the liquid composition in accordance with the present invention and the skilled person will select suitable substances dependent on his specific needs of the individual case based on his professional knowledge. By way of example ionic salts possibly useful as dopants like e.g. cesium carbonate, lithium fluoride or potassium tetrakis(pentafluorophenyl)borate or inert polymers possibly useful as matrices like polystyrene or poly(methylmethacrylate) may be mentioned.

While the amount of the additional ingredients besides the organic semiconducting material present in the liquid composition can vary broadly, it has been found advantageous in certain case if the solvent preparation and the organic semiconducting material comprise at least 50, more preferably at least 75 and even more preferably 90 % or more of the liquid composition. In some cases it has proven to be advantageous if the liquid composition consists essentially of or consists of the at least one semiconducting material and the solvent preparation.

The liquid composition may be deposited onto the surface of the substrate by any suitable solution processing technique known in the art.

By way of example printing processes like inkjet printing, offset printing, transfer printing or screen printing or coating processes like spray coating, spin coating or dip coating may be mentioned. The skilled person knows how to operate such techniques and will select the appropriate conditions based on his knowledge and the specific conditions of the individual situation.

After deposition of the liquid composition onto the substrate, the solvent is usually removed, which solvent removal may be effected by any known method like e.g. vacuum drying or heating.

In some embodiment the organic semiconductor material may comprise crosslinkable groups and accordingly a crosslinking may be effected prior to the deposition of the next layer. Such crosslinking may improve the stability of the deposited layer and may be advantageous when depositing the next layer on top of the first layer, where it is generally desirable that the preceding layer on top of which the subsequent layer is deposited is not influenced or damaged by the subsequent deposition step. Cross linking may be achieved thermally or through radiation and the skilled man knows suitable techniques so that no detailed description is necessary here.

The process in accordance with the present invention is broadly applicable in the formation of organic layers in organic electronic devices like organic electronic diodes, photovoltaic devices or OLEDs. The process is particularly suitable for the manufacture of layers in multilayered organic light emitting diodes (OLEDs) comprising a multiplicity of different layers either based on the same or on different matrix materials (so called homojunction or heterojunction OLEDs).

Another aspect of the present invention relates to the use of a solvent preparation comprising at least one solvent and at least one organic semiconducting material and having a water content of less than 40 ppm for the manufacture of layers of organic electronic devices, in particular organic light emitting diodes.

Still another aspect of the invention relates to layers of organic electronic devices obtainable by the process in accordance with the present invention and to organic electronic devices, in particular organic light emitting diodes comprising at least one layer obtainable in accordance with the process of the present invention.

The lifetime of organic electronic devices is significantly improved by reducing the water content in the solvent preparation as claimed in the process of the present invention which constitutes an important economical and technical advantage.

Usually commercially available solvents like e.g. toluene do not fulfil the water content requirement for the process of the present invention and thus further treatment might be necessary. There are some special grades of solvents available where the water content has already been reduced and they might in certain cases be suitable without further treatment. The water content in the solvent preparation used may be reduced to the desired level of less than 40 ppm by appropriate techniques known to the skilled person like e.g. distillation, drying etc. The reduction of water content, if necessary may be effected immediately prior to use or separately. In the latter case the solvent should be stored properly to avoid uptake of water during storage.

By way of example for toluene, a reduction of the water content may be achieved by the following distillation procedure: All glassware is dried at 150 ° C for 1 h in an oven. The empty bottles are pre-rinsed with anhydrous toluene and dried at 150 ° C for 1 h in a glove box. The following steps are all carried out in a glove box. Anhydrous toluene is placed in a dry flask, which is then connected to the distillation column. A condenser is placed above the assembly. A piece of sodium is rinsed with n-hexane and anhydrous toluene, then it is placed in the distillation flask. The flask is heated to reflux using a heating mantle. The distillation head (~10ml) is removed and the toluene is collected in a dried flask. The collected toluene is distilled a second time by repeating the above procedure. Following this procedure water contents of as low as 2 ppm or less may be obtained.

The determination of the water content of the solvent preparation useful in the process of the present invention may be done through methods commonly applied for such purposes. Only by way of example, Karl-Fischer titration may be mentioned here; but he skilled person will chose the suitable method based on his technical knowledge.

The following examples show the benefit of the process of the present invention.

### Device preparation

All device examples were fabricated by a combination of high vacuum thermal evaporation and solution process (spin-coating). The anode electrode was 120 nm of indium tin oxide (ITO). All devices were encapsulated with a glass lid sealed with an epoxy resin in a nitrogen glovebox (<1 ppm of H2O and 02) immediately after fabrication, and a moisture getter was incorporated inside the package. The devices were characterized optically and electrically with a C9920-12 External Quantum Efficiency Measurement System from HAMAMATSU. EQE refers to external quantum efficiency expressed in %, while operational stability tests were done by driving the devices at continuous current at room temperature. LT₉₀ and LT₅₀ are measures of lifetime and correspond to the time for light output to decrease to 90% and respectively to 50% of the initial value, when the device is driven at a constant current.

The water content of the different grades of toluene used in these examples was determined by the well-established and widely accepted coulometric Karl Fisher titration method. For the principles of the method reference is made to ASTM standard E1064. The coulometric Karl Fischer titrator was a Metrohm 756 KF coulometer with a 350 ml Metrohm titration cell (Metrohm ref. 6.1464.320 - 350 ml), Metrohm dual platinum sensing electrodes, (Metrohm ref. 6.0341.100), a Metrohm generator electrode without diaphragm (Metrohm ref. 6.0345.100) and a Metrohm 728 magnetic stirrer. The Karl Fisher reagent used was *Hydrana*/*®-Coulomat AG-Oven* from Riedel-de-Haën. A quantity between 8 and 10 g of toluene was sampled from the bottle in a nitrogen-flushed glove box using a dry 10 ml hypodermic syringe. The hypodermic needle was sealed with a small piece of rubber septum during the transfer of the sample from the glove box to the titration cell. The injected sample mass was determined by the mass difference of the syringe before and after injection through the cell's injection septum. The method used complies with the ASTM E1064 Standard Test Method for Water in Organic Liquids by Coulometric Karl Fisher Titration, with only the following deviations, which don't influence the result: 1. because of the low water content (< 10 mg/kg) approximately 10 ml of sample was used instead of the 5 ml mentioned as a guide value in the standard, and 2. during analysis the titration cell was continuously flushed with a 6 l/min flow of dry argon in order to avoid any entry of water vapour from the ambient air into the titration cell. The method used is accredited according to ISO17025 by the Belgian Accreditation Body BELAC.

### Examples 1C to 4 - Impact of water content of solvent in the manufacture of an HTL layer of an OLED

The OLED stack consisted of sequentially, from the ITO surface, 60 nm of Plexcore OC (a self-doping polymer poly(thiophene-3-[2[(2-methoxyethoxy)ethoxy]-2,5-diyl), supplied from Plextronics Inc.) 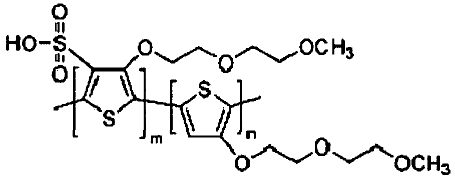 deposited by spin-coating and dried on a hot plate at 200 °C for 20 min. On top of the HIL, a hole transporting layer (HTL) of 30 nm was also deposited by spin-coating. The HTL was made by spin-coating a 0.5 wt% solution of Compound A in toluene, which was then dried on a hot plate at 160 °C for 15 min.

Then a 20nm layer of Compound B doped with 20% of tris(2-phenylquinoline)iridium(III) [Ir(2-phq)₃] was deposited by vacuum-thermal evaporation as the emissive layer (EML). Then a 10nm layer of bis(2-methyl-8-quinolinolate)-4-(phenylphenolato)aluminium (BAlq) was deposited by vacuum-thermal evaporation as the hole blocking layer (HBL). Then, a 45 nm layer of BPhen:Cs (BPhen = 4,7-Diphenyl-1,10-phenanthroline) was deposited by vacuum-thermal evaporation as the electron transporting layer (ETL). The cathode consisted of 100 nm of Al. As used herein, Compound A, Compound B, Ir(phq)₃, BAlq and BPhen have the following structures:

### Compound A

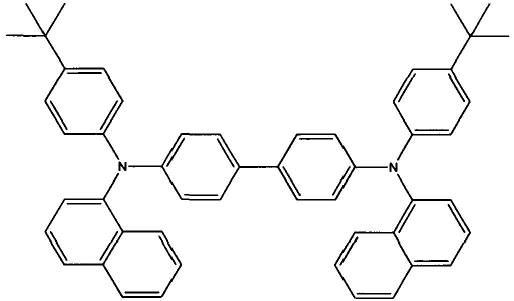

### Compound B

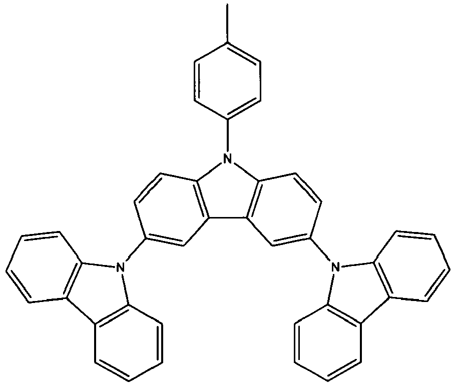

### Ir(2-phq)₃

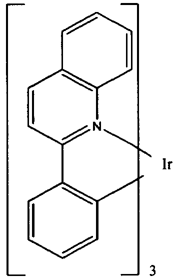

### Balq

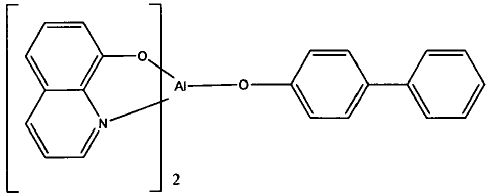

### BPhen

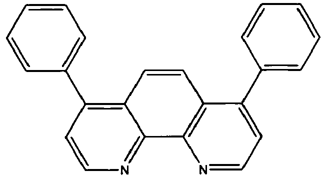

Four different solutions for the manufacture of the HTL layer were prepared, each with a toluene of different water content. The water content was determined as described hereinbefore by coulometric KARL FISCHER titration. Table 2 summarizes the device performances as a function of water content of the solvent used.

**Table 2**

| Example | HTL solvent | Water content solvent (ppm) | EQE at 1000 Cd/m² in % | Voltage at 1000 Cd/m² (V) | LT 90 at 2000 Cd/m² h |
|---|---|---|---|---|---|
| 1C | Toluene | 80 | 1.4 | 3.9 | 1.3 |
| 2 | Toluene | 25 | 5.3 | 3.4 | 20 |
| 3 | Toluene | 9 | 5.3 | 3.3 | 181 |
| 4 | Toluene | 12 | 5.2 | 3.2 | 194 |

Device Example 2, which includes an HTL deposited by a toluene solution having 25 ppm of water content, showed an improved efficiency and lifetime over Comparative Example 1C, which included an HTL deposited by a toluene solution having 80 ppm of water content. Furthermore, Device Example 3 and Device Example 4 (which included an HTL deposited with a toluene solution having 9 ppm and 12 ppm of water content, respectively) show a significantly higher operational stability over Comparative Device Example 1C and also show a further improvement over Device Example 2.

Comparable results are obtained when manufacturing other layers of an organic electronic device, i.e. the beneficial effect of the process in accordance with the present invention is achieved for any layer of an organic electronic device and thus all layers of such devices may be preferably synthesized in accordance with the process of the present invention.

The foregoing examples show that controlling and, if necessary reducing the water content of the solvents used for manufacturing OLED layers has a marked influence on the performance and lifetime properties of the device. This is surprising and would not have been expected, in particular in view of the fact that for a long time OLEDS have been fabricated with PEDOT:PSS as HIL which was deposited from a water based formulation.

## Claims

1. A process for forming an organic layer of an organic electronic device comprising the steps of providing a liquid composition containing at least one organic semiconducting material and a solvent preparation and depositing the liquid composition onto a surface of a substrate wherein a solvent preparation is used which has a water content of 40 ppm or less, based on the weight of the solvent preparation.

2. The process in accordance with claim 1 wherein the water content of the solvent preparation is 25 ppm or less.

3. The process in accordance with claim 1 or 2 wherein the water content of the solvent preparation is 15 ppm or less.

4. The process in accordance with any of the preceding claims wherein the solvent or solvents in the solvent preparation have a boiling point in the range of from 80 to 300 °C.

5. The process in accordance with any of the preceding claims wherein the solvent preparation comprises or consists essentially of an aromatic solvent.

6. The process in accordance with claim 6 wherein the aromatic solvent is selected from the group consisting of alkyl substituted aromatic solvents.

7. The process in accordance with claim 6 wherein the aromatic solvent is selected from the group consisting of toluene or the isomeric xylenes.

8. Use of a solvent preparation comprising less than 40 ppm, based on the weight of the solvent preparation for the manufacture of layers of organic electronic devices.

9. Organic layer of an organic electronic device obtainable in accordance with the process of any of claims 1 to 7.

10. Organic electronic device comprising at least one layer obtainable in accordance with the process of any of claims 1 to 7.

11. Organic electronic device in accordance with claim 10 which is an organic light emitting diode.
